# EUROPEAN PATENT SPECIFICATION

(11) **EP 0 691 413 B1**
(45) Date of publication and mention of the grant of the patent: **01.07.1998**
(21) Application number: 95114320.5
(22) Date of filing: 05.04.1994
(51) Int. Cl.: C22C 1/09, C22C 29/00

(54) **Diamond reinforced composite material and method of preparing the same**
Diamantverstärktes Verbundmaterial und Verfahren zu dessen Herstellung
Matériau composite renforcé par du diamant et méthode pour sa préparation

(30) Priority: 06.04.1993 JP 79611/93
(43) Date of publication of application: 10.01.1996
(62) Divisional of application: 94105241.7
(73) Proprietor: Sumitomo Electric Industries, Ltd., Osaka 541 (JP)
(72) Inventor: Yamamoto, Yoshiyuki, c/o Itami Works, 1-1, Koyakita 1-chome, Itami-shi, Hyogo (JP); Imai, Takahiro, c/o Itami Works, 1-1, Koyakita 1-chome, Itami-shi, Hyogo (JP); Tsuno, Takashi, c/o Itami Works, 1-1, Koyakita 1-chome, Itami-shi, Hyogo (JP); Fujimori, Naoji, c/o Itami Works, 1-1, Koyakita 1-chome, Itami-shi, Hyogo (JP)
(74) Representative: Bockhorni, Josef, Dipl.-Ing.

(56) References cited:
- EP-A- 0 378 378
- EP-A- 0 493 351
- GB-A- 1 374 513
- US-A- 4 268 276
- US-A- 4 957 591
- DATABASE WPI Section Ch, Week 8516 Derwent Publications Ltd., London, GB; Class L02, AN 85-095848 & JP,A,60 043 461 ( TOSHIBA TUNGALLOY KK) , 8 March 1985
- DATABASE WPI Section Ch, Week 9009 Derwent Publications Ltd., London, GB; Class L02, AN 90-063214 & JP,A,02 015 977 ( NISSHIN DIAMOND KK) , 19 January 1990
- DATABASE WPI Section Ch, Week 8409 Derwent Publications Ltd., London, GB; Class E36, AN 84-054051 & SU,A,549 935 ( AS UKR HARD MATERIALS) , 30 July 1983

## Description

### BACKGROUND OF THE INVENTION

### Field of the Invention

The present invention relates to a diamond reinforced composite material for forming a component which must have lightweightness, high elasticity, high strength and high heat resistance in relation to an aircraft, an engine, an acoustic product or sports goods, and a method of preparing the same.

### Description of the Background Art

In general, a component which must have lightweightness, high elasticity, high strength or high heat resistance in relation to an aircraft, an engine, an acoustic product or sports goods is generally made of an aluminum alloy such as duralumin, or a fiber reinforced composite material such as a carbon fiber reinforced composite material. Well-known examples of the fiber reinforced composite material are carbon fiber reinforced resin (CFRP), a carbon fiber reinforced metal prepared by dispersing carbon fiber in a metal, and various ceramics fiber reinforced composite materials prepared by dispersing SiC fiber, glass fiber, SiC whisker, glass whisker and the like in metals or plastic materials. The fiber reinforced composite material having high strength is increasingly employed in recent years since the same is lighter than an aluminum alloy such as duralumin.

On the other hand, there have recently been proposed techniques of obtaining fibrous, needle-shaped or whiskery vapor-deposited diamond from a raw material of a mixed gas of hydrogen and hydrocarbon. For example, Japanese Patent Laying-Open No. 60-200896 (1985) discloses a technique of depositing fibrous diamond on a surface of a substrate containing transition metal particles of not more than 1000 Å in size adhering thereto from a raw material gas which is excited and decomposed under decompression. Japanese Patent Laying-Open No. 1-246116 (1989) discloses a technique of obtaining needle-shaped, fibrous or porous diamond by exposing a vapor-deposited diamond film to plasma containing oxygen, carbon dioxide, water steam, hydrogen, halogenated hydrocarbon or halogenated carbon, or heat treating the film in an air current containing oxygen, carbon dioxide or water steam. Japanese Patent Laying-Open No. 2-239192 (1990) discloses a technique of etching a vapor-deposited crude diamond film for converting the same to a needle-shaped diamond film and depositing pure diamond on the needle-shaped diamond film. Japanese Patent Laying-Open No. 1-246116 (1989) suggests such a potential that a diamond reinforced composite material having an excellent mechanical, thermal or chemical property such as high strength, high wear resistance, high heat conductivity or high corrosion resistance may be prepared by combining needle-shaped, fibrous or porous diamond with another matrix material.

In general, important technical subjects in relation to preparation of a fiber reinforced composite material are adhesion and bondability between materials to be combined with each other, i.e., a matrix and a reinforcing fiber material. Diamond has the maximum hardness and the maximum modulus of elasticity among materials. Since fibrous diamond is superior in hardness and modulus of elasticity to a reinforcing fiber material of carbon, SiC or glass, it is expected that a composite material which is reinforced with the fibrous diamond may attain higher strength than those reinforced with other fibrous materials. However, vapor-deposited diamond is inferior in adhesion and bondability with respect to another material such as a metal or plastic, and hence it is difficult to obtain a strongly bonded state by dispersing fibrous diamond in a matrix. Further, diamond is generally inferior in wettability with respect to another material such as a metal or plastic. Therefore, the range of raw materials for a matrix is restricted in relation to a diamond reinforced composite material, due to insufficiency of materials having excellent adhesion and bondability with respect to vapor-deposited diamond.

### SUMMARY OF THE INVENTION

An object of the present invention is to improve adhesion or bonding between vapor-deposited diamond and a matrix in relation to a diamond reinforced composite material.

Another object of the present invention is to widen the range of materials which are employable for a matrix in relation to a diamond reinforced composite material.

The present invention provides a composite material which is reinforced with vapor-deposited diamond. In this composite material, the surface of the diamond is modified to be improved in bondability to the matrix.

A composite material according to an aspect of the present invention comprises a matrix and a reinforcing material, consisting essentially of vapor-deposited diamond, which is dispersed in the matrix which consists essentially of organic polymers. In this composite material, the amount of hydrogen atoms which are present in a portion corresponding to an interface between the vapor-deposited diamond and the matrix is not more than about 1 x 10¹⁵/cm².

A composite material according to another aspect of the present invention comprises a matrix and a reinforcing material, mainly composed of vapor-deposited diamond, which is dispersed in the matrix which consists essentially of organic polymers. The reinforcing material has a layer which is more strongly bonded to the matrix as compared with the diamond itself at least in a boundary portion between the same and the matrix, so that this layer further reinforces bonding between the diamond and the matrix as compared with that in the absence thereof.

According to still another aspect of the present invention, provided is a method of preparing a diamond reinforced composite material which comprises a step of providing vapor-deposited diamond serving as a reinforcing material, a step of removing hydrogen from the surface of the vapor-deposited diamond, and a step of mixing the vapor-deposited diamond with a matrix material for forming a composite material, wherein said matrix consists essentially of organic polymers.

According to a further aspect of the present invention, provided is a method of preparing a diamond reinforced composite material comprising a step of preparing a reinforcing material, mainly composed of vapor-deposited diamond, having a layer which can be strongly bonded to a matrix material as compared with the diamond at least on its surface, and a step of mixing the reinforcing material with the matrix material for forming a composite material, wherein said matrix consists essentially of organic polymers.

According to the present invention, the reinforcing material can consist essentially of at least one vapor-deposited diamond selected from the group of needle-shaped diamond, diamond fiber, diamond whisker and porous diamond, and combinations thereof.

The foregoing and other objects, features, aspects and advantages of the present invention will become more apparent from the following detailed description of the present invention when taken in conjunction with the accompanying drawings.

### BRIEF DESCRIPTION OF THE DRAWING

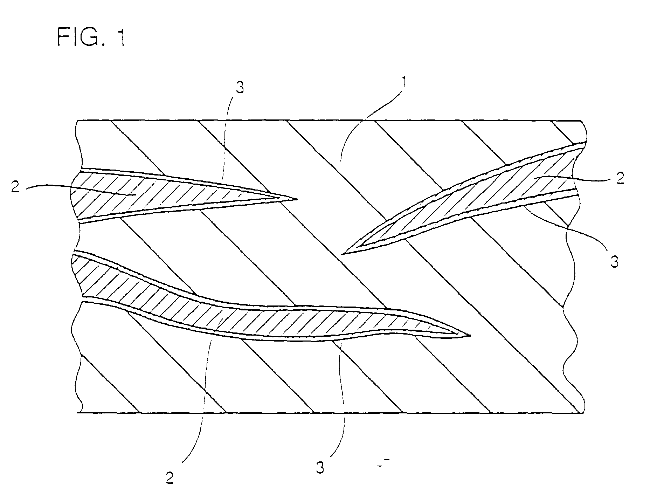

Fig. 1 is a sectional view typically showing an exemplary composite material according to the present invention. Reinforcing materials 2 consisting essentially of diamond are dispersed in a matrix 1. The reinforcing materials 2 are provided on surfaces thereof with intermediate layers 3 for improving bonding between the matrix 1 and the diamond.

### DESCRIPTION OF THE PREFERRED EMBODIMENTS

In a preferred mode of the present invention, hydrogen is removed from the surface of vapor-deposited diamond serving as a reinforcing material. The inventors have investigated the cause for insufficiency in bonding strength between vapor-deposited diamond and a matrix, to find that hydrogen which is bonded to the surface of the diamond during the vapor deposition process inhibits bonding between the matrix and the diamond. When the matrix is prepared from a metal, for example, a fragile metal hydrogen compound is formed by such hydrogen on an interface between the matrix and the diamond. This compound depresses bonding between the diamond and the metal. When the reinforcing materiai is prepared from vapor-deposited diamond, therefore, it is important to remove hydrogen which is bonded to its surface. Also when the matrix is prepared from resin, removal of hydrogen brings stronger bonding between the diamond and the resin. According to the present invention, the amount of hydrogen atoms which are bonded onto the diamond surface is reduced to not more than about 1 x 10¹⁵/cm². In practice, the amount of hydrogen atoms which are present on a diamond surface is about 1.5 x 10¹³/cm² to about 1 x 10¹⁵/cm², preferably about 1.5 x 10¹³/cm² to about 2 x 10¹⁴/cm², for example. Particularly when the matrix is prepared from an organic polymer, the surface of vapor-deposited diamond containing not more than about 1 x 10¹⁵/cm² of hydrogen atoms is bonded to the matrix with sufficient strength, to provide a diamond reinforced composite material.

The step of removing hydrogen from the surface of vapor-deposited diamond may include a step of heat treating the diamond under an oxidative atmosphere at a temperature of about 150°C to about 800°C. The oxidative atmosphere can be prepared from air or an atmosphere containing oxygen in an amount identical to or exceeding that of air. Under such an oxidative atmosphere, it is impossible to sufficiently effectively remove hydrogen which is bonded to carbon atoms forming the vapor-deposited diamond at a temperature of less than 150°C. When the temperature exceeds 800°C, on the other hand, the diamond may be strongly corroded under the oxidative atmosphere. It is possible to heat vapor-deposited diamond under a non-oxidative atmosphere at a temperature of about 800°C to about 1500°C, in order to remove hydrogen from the surface of the diamond. The non-oxidative atmosphere can be prepared from inert gas or a vacuum, for example. Under the non-oxidative atmosphere, a temperature of less than 800°C is insufficient for uncoupling hydrogen from carbon atoms. When the temperature exceeds 1500°C, on the other hand, the diamond may be corroded also under the non-oxidative atmosphere. The step of removing hydrogen from the surface of vapor-deposited diamond can include a step of exposing the diamond into plasma containing oxygen. In this case, it is possible to uncouple hydrogen bonded onto the diamond surface under the room temperature.

It is possible to form a layer consisting essentially of a material other than diamond or doped diamond at least on a surface of vapor-deposited diamond for improving bonding strength between the diamond and a matrix through this layer. This intermediate layer is strongly bonded to both of the diamond and the matrix. The intermediate layer is a coating covering the surface of the diamond, and this coating consists essentially of at least one material selected from the group consisting of Aℓ, Si, B, Ti, V, Cr, Mn, Fe, Co, Ni, Zr, Nb, Mo, Hf, Ta and W, and alloys thereof, a carbide, a nit=ide and a boride thereof, and combinations thereof. Such a coating can be formed by CVD or PVD technique. For example, it is possible to expose diamond which is heated at a temperature of about 1000°C to about 1500°C to a gas containing Si, thereby forming an SiC layer on its surface. SiC, which can adhere to a metal such as Aℓ, resin or ceramics with sufficient strength, improves bonding between the diamond and the matrix. In a preferred mode, the intermediate layer consists essentially of graphite. Such a graphite layer can be formed by heating the surface of the diamond, for example. Heating vapor-deposited diamond under a non-oxidative atmosphere at a temperature of about 1000°C to about 1500°C, can convert the surface of the diamond to a graphitic carbon layer. In this case, formation of the graphite is not much progressed under a temperature of less than 1000°C, while the overall diamond may disadvantageously be converted to graphite if the temperature exceeds 1500°C.

In still another preferred mode, the intermediate layer or the reinforcing material itself can consist essentially of vapor-deposited diamond doped with boron (B), nitrogen (N) or a combination thereof. B and N can be doped into diamond in large amounts without damaging mechanical properties of the diamond, to improve the surface of the diamond in bonding to the matrix. B and N are suitable as impurities in points that the same can be doped in considerable amounts and that the same will not deteriorate mechanical properties of the diamond.
Further, B and N can be easily introduced into the diamond as impurities in vapor deposition of the diamond. B or N doped diamond can be vapor-deposited in accordance with a conventional technique, such as that disclosed in Japanese Patent Laying-Open No. 58-135117 (1983) or 59-137396 (1984), for example. Concentration of B, N or a combination thereof which is contained in the diamond is preferably in a range of about 50 ppm to about 20000 ppm. Diamond doped with less than 50 ppm of such an impurity is insufficient in improvement in bondability to the matrix. If the impurity concentration exceeds 20000 ppm, on the other hand, the doped diamond is reduced in strength. In order to introduce a large amount of impurity into the diamond without reducing strength of the diamond itself, it is more preferable to simultaneously and homogeneously dope the diamond with B and N at a mole weight ratio of 1:1. A process of forming a diamond reinforcing material which is coated with such doped diamond can comprise steps of forming diamond by vapor deposition, and vapor-depositing a diamond layer on the diamond while doping the same with B, N or a combination thereof.

When the matrix is prepared from an organic polymer, the diamond can be combined with thermoplastic resin or thermosetting resin. Examples of the thermoplastic resin are addition polymerization polyethylene, polypropylene, polyvinyl chloride, polystyrene, polyvinylidene chloride, fluororesin, polymethyl methacrylate, polycondensation polyamide, polyester, polycarbonate, polyphenylene oxide, polyaddition thermoplastic polyurethane and ring-opening polymerization polyacetal. The mixture of the thermoplastic resin and the diamond having a modified surface may be molded by ordinary injection molding, to a composite material. On the other hand, examples of the thermosetting resin are urea resin, melamine resin and phenol resin. When the matrix is prepared from such thermosetting resin, it is possible to prepare a composite material by mixing a liquid type matrix with diamond having a modified surface, and heating the mixture for hardening the same. Other materials such as polyimide, polyphenylene, sulfide, polyether sulfone, polyetherketone, polyimide, epoxy resin and the like may be used as the resin matrix.

When the surface of diamond is reformed in accordance with the present invention, bonding between the diamond and the matrix material is remarkably improved. This brings not only a composite material which is excellent in mechanical strength but a composite material having a large area or a long size. If vapor-deposited diamond with no modification on its surface, is mixed with a matrix the composite material as obtained has inferior strength and it is difficult to obtain a composite material having a large area or a long size. The composite material according to the present invention has excellent wear resistance, heat conductivity, heat resistance, corrosion resistance and radiation resistance, and high mechanical strength. The composite material according to the present invention can be applied to a use in a wider range and under severer conditions as compared with the prior art. For example, the composite material according to the present invention can provide a sliding material with a longer life than that of the prior art, due to excellent wear resistance. Further, the composite material according to the present invention which is resistant against radiation can be employed for forming the airframe of a space aircraft. In addition, the present invention widens the range of materials employable for a matrix by improving bondability of diamond to the matrix.

Examples of the present invention are now described in detail.

### Example 1

According to the technic disclosed by Japanese Patent Laying-Open No. 1-246116 (1989), diamond as a reinforcing material was prepared as follows.

A diamond film of about 100 µm in thickness was deposited on a silicon substrate in microwave plasma CVD. CVD conditions were as follows:
Raw Material: mixed gas of 3 % of methane and hydrogen
Pressure: 40 Torr
Substrate Temperature: 850°C

The diamond film as obtained was exposed to hydrogen plasma of 80 Torr in pressure in a plasma etching apparatus at a temperature of 980°C for about 20 minutes. The silicon substrate was dissolved with a dilute mixed solution of hydrofluoric acid and nitric acid, to separate the treated film from the substrate. As the result, the diamond film which was cracked by the plasma treatment was finely decomposed, to provide needle-shaped and fibrous diamonds (hereinafter referred to as diamond fiber) having an average length of about 100 µm and an average diameter of about 5 µm.

About 2 g of the diamond fiber as obtained was introduced into a reaction chamber, and held in the air at 500°C for about 1 hour. Thus, hydrogen was removed from the surface of the diamond. Since it was difficult to directly measure an amount of hydrogen on the surface of the diamond fiber, the following experiment was carried out. The diamond film on a single-crystal diamond substrate as obtained under the above conditions was introduced into the reaction chamber, and held in the air at 500°C for about 1 hour. An amount of hydrogen atoms on the diamond film surface was then measured by the elastic recoil detection (ERD), and the value of 9.6 x 10¹³/cm² was obtained as the amount of hydrogen atoms. This result suggested about 9.6 x 10¹³/cm² of hydrogen atoms on the surface of the diamond fiber. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample A was prepared from the diamond reinforced resin as obtained, and subjected to measurement of the modulus of elasticity and tensile strength. Table 1 shows the results.

### Example 2

About 2 g of the diamond fiber obtained in Example 1 was introduced into a reaction chamber, and held in a vacuum of 10⁻⁴ Torr at 1200°C for 1 hour. The analysis by the surface sensitization Raman spectroscopy resulted in 0.91 value as a peak ratio (Y/X) of the graphite carbon peak value (Y) to the diamond carbon peak value (X). As a result, it was confirmed that graphite was formed on the diamond surface. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample B was prepared from the composite material as obtained, and subjected to measurement of the modulus of elasticity and tensile strength. Table 1 shows the results.

### Example 3

About 2 g of the diamond fiber obtained in Example 1 was introduced into a reaction chamber, and exposed to a water steam atmosphere of 0.2 Torr, to which a highfrequency discharge of 80 W was applied, under the room temperature for 10 minutes. Thus, hydrogen was removed from the surface of the diamond. 2 g of the diamond fiber whose surface was reformed in the aforementioned manner was mixed with 20 g of a commercially available polyethylene pellet, and the mixture was heated in the atmosphere to 400°C and injection-molded, to prepare diamond reinforced polyethylene resin. A sample C was prepared from the composite material as obtained, and subjected to measurement of the modulus of elasticity and tensile strength. Table 1 shows the results.

### Example 4

The surface of the diamond fiber obtained in Example 1 was coated with Ti in a thickness of about 0.02 µm by well-known sputtering. 2 g of the diamond fiber having the Ti layer on its surface was mixed with 20 g of a commercially available polyethylene pellet, and the mixture was heated in the atmosphere to 400°C and injection-molded, to prepare diamond reinforced polyethylene resin. A sample D was prepared from the composite material as obtained, and subjected to measurement of the modulus of elasticity and tensile strength. Table 1 shows the results.

### Comparative Example 1

About 2 g of the diamond fiber obtained in Example 1 was introduced into a reaction chamber, and exposed to a hydrogen atmosphere of 5 Torr, to which a microwave discharge of 150 W was applied, under the room temperature for about 30 minutes. On the other hand, the diamond film on the single-crystal diamond substrate as obtained in Example 1 was introduced into the reaction chamber, and exposed to a hydrogen atmosphere of 5 Torr, to which a microwave discharge of 150W was applied under the room temperature for about 30 minutes. An amount of hydrogen atoms on the diamond film surface was then measured by ERD, and the value of 2.4 x 10¹⁵/cm² was obtained. This result suggested at least 2.4 x 10¹⁵/cm² of hydrogen atoms on the surface of the diamond fiber. 2 g of the diamond fiber as treated was mixed with 20 g of a commercially available polyethylene pellet, and the mixture was heated in the atmosphere to 400°C and injection-molded, to prepare diamond reinforced polyethylene resin. A sample E Was prepared from the composite material as obtained, and subjected to measurement of the modulus of elasticity and tensile strength. Table 1 shows the results.

### Comparative Example 2

The diamond fiber obtained in Example 1 was employed for forming a composite material as such with no treatment on its surface. 2 g of the diamond fiber was mixed with 20 g of a commercially available polyethylene pellet, and the mixture was heated in the atmosphere to 400°C and injection-molded, to prepare diamond reinforced polyethylene resin. A sample F was prepared from the composite material as obtained, and subjected to measurement of the modulus of elasticity and tensile strength. Table 1 shows the results.

**Table 1**

| Sample | Modulus of Elasticity (GPa) | Tensile Strength (MPa) |
|---|---|---|
| A | 105 | 360 |
| B | 125 | 420 |
| C | 110 | 450 |
| D | 120 | 510 |
| E | 90 | 80 |
| F | 94 | 150 |

From the results shown in Table 1, it was confirmed that each diamond reinforced polyethylene resin according to the present invention was improved in both of the modulus of elasticity and tensile strength as compared with each comparative example.

## Claims

1. A diamond reinforced composite material comprising:
a matrix (1); and
a reinforcing material (2) dispersed in said matrix (1) and composed mainly of vapor-deposited diamond,
said reinforcing material having a layer (3) that bonds more strongly to said matrix than does said diamond itself, at least at a boundary portion between said reinforcing material (2) and said matrix (1),
**characterized in that**
said matrix (1) consists essentially of organic polymers,
wherein said layer (3) further enhances bonding between said reinforcing material (2) and said matrix (1) as compared with the bonding in the absence of said layer.

2. The diamond reinforced composite material in accordance with claim 1, wherein said reinforcing material consists essentially of vapor-deposited diamond selected from the group consisting of needle-shaped diamond, diamond fiber, diamond whisker and porous diamond, and combinations thereof.

3. The diamond reinforced composite material in accordance with claim 1 or 2, wherein said layer (3) consists essentially of graphite.

4. A diamond reinforced composite material according to claim 2
wherein said reinforcing material (2) includes diamond doped with dopant atoms of at least one material selected from the group consisting of B, N and a combination thereof.

5. The diamond reinforced composite material in accordance with claim 4, wherein said doped diamond forms said layer (3).

6. The diamond reinforced composite material in accordance with claim 4 or 5, wherein the total dopant concentration of said dopant atoms in the range from about 50 ppm to about 20,000 ppm.

7. The diamond reinforced composite material (2) in accordance with claim 4 or , wherein said doped diamond includes B and N with the ratio of B to N being about 1:1.

8. The diamond reinforced composite material (2) in accordance with claim 4, wherein the amount of hydrogen atoms present in said vapor-deposited diamond at the interface portion between said diamond and said matrix is not more than about 1 x 10¹⁵/cm² for improving bonding between said reinforcing material and said matrix.

9. The diamond reinforced composite material in accordance with claim 8, wherein said amount of hydrogen atoms is in the range from about 1,5 x 10¹³/cm² to about 1 x 10¹⁵/cm².

10. The diamond reinforced composite material in accordance with claim 8, wherein said amount of hydrogen atoms is in the range from about 1,5 x 10¹³/cm² to about 2 x 10¹⁴/cm².

11. A method of preparing a diamond reinforced composite material, comprising:
a step of preparing a reinforcing material (2) being mainly composed of vapor-deposited diamond, having a layer (3) capable of being more strongly bonded to a matrix (1) as compared with said diamond at least on its surface; and a step of mixing said reinforcing material with a matrix material for forming a composite material,
wherein said layer (3) is obtained by heating the surface of said diamond serving as said reinforcing material for converting the same to graphite,
**characterized in that**
said diamond consists essentially of vapor-deposited diamond selected from the group consisting of needle-shaped diamond, diamond fiber, diamond whisker and porous diamond, and combinations thereof,
and said matrix (1) consists essentially of organic polymers.

12. A method of preparing a diamond reinforced composite material comprising:
a step of preparing a reinforcing material (2) being mainly composed of vapor-deposited diamond, having a layer (3) capable of being more strongly bonded to a matrix (1) as compared with said diamond at least on its surface; and
a step of mixing said reinforcing material with a matrix material for forming a composite material,
**characterized in that**
said layer is obtained by vapor-depositing diamond being doped with at least one element selected from the group consisting of B, N and a combination thereof, and
said matrix (1) consists essentially of organic polymers.

13. The method of preparing a diamond reinforced composite material in accordance with claim 12,
wherein said diamond consists essentially of vapor-deposited diamond selected from the group consisting of needle-shaped diamond, diamond fiber, diamond whisker and porous diamond, and combinations thereof.

## Patentansprüche

1. Diamantverstärktes Verbundmaterial, welches umfaßt:
eine Matrix (1); und
ein verstärkendes Material (2), welches in der Matrix (1) verteilt ist und hauptsächlich aus aufgedampften Diamant zusammengesetzt ist;
wobei das verstärkende Material eine Schicht (3) hat, die sich stärker mit der Matrix (1) verbindet als der Diamant selber, zumindest an einem Grenzbereich zwischen dem verstärkenden Material (2) und der Matrix (1),
**dadurch gekennzeichnet, daß**
die Matrix (1) im wesentlichen aus organischen Polymeren besteht,
worin die Schicht (3) weiterhin die Verbindung zwischen dem verstärkenden Material (2) und der Matrix (1) im Vergleich zu der Verbindung bei Abwesenheit der Schicht erhöht.

2. Diamantverstärktes Verbundmaterial nach Anspruch 1, worin das verstärkende Material im wesentlichen aus aufgedampftem Diamant besteht, der aus der Gruppe ausgewählt ist, die aus nadelförmigem Diamant, Diamantfaser, Diamatwhisker und porösem Diamant und Verbindungen davon besteht.

3. Diamantverstärktes Verbundmaterial nach Anspruch 1 oder 2, worin die Schicht (3) im wesentlichen aus Graphit besteht.

4. Diamantverstärktes Verbundmaterial nach Anspruch 2, worin das verstärkende Material (2) Diamant beinhaltet, der mit Dotierungsatomen aus mindestens einem Material, das aus der Gruppe ausgewählt wird, die aus B, N und Verbindungen davon besteht, dotiert ist.

5. Diamantverstärktes Verbundmaterial nach Anspruch 4, worin der dotierte Diamant die Schicht (3) bildet.

6. Diamantverstärktes Verbundmaterial nach Anspruch 4 oder 5, worin der gesamte Dotierungsgrad der Dotierungsatome in dem Bereich von 50 ppm bis ungefähr 20.000 ppm ist.

7. Diamantverstärktes Verbundmaterial (2) nach Anspruch 4 oder 5, worin der dotierte Diamant B und N mit dem Verhältnis von B zu N von ungefähr 1 : 1 beinhaltet.

8. Diamantverstärktes Verbundmaterial (2) nach Anspruch 4, worin der Betrag an Wasserstoffatomen, die in dem aufgedampften Diamant an den Schnittstellenbereichen zwischen dem Diamant und der Matrix vorhanden sind, nicht mehr als 1 x 10¹⁵/cm² zum Verbessern der Verbindung zwischen dem verstärkenden Material und der Matrix ist.

9. Diamantverstärktes Verbundmaterial nach Anspruch 8, worin der Betrag an Wasserstoffatomen in dem Bereich von ungefähr 1,5 x 10¹³/cm² bis ungefähr 1 x 10¹⁵/cm² ist.

10. Diamantverstärktes Verbundmaterial nach Anspruch 8, worin der Betrag an Wasserstoffatomen in dem Bereich von ungefähr 1,5 x 10¹³/cm² bis ungefähr 2 x 10¹⁴/cm² ist.

11. Verfahren zur Herstellung eines diamantverstärkten Verbundmaterials, welches umfaßt:
einen Schritt des Herstellens eines verstärkenden Materials (2), welches hauptsächlich aus aufgedampften Diamant zusammengesetzt ist, welches eine Schicht (3) hat, die es ermöglicht, stärker mit einer Matrix (1) im Vergleich zu dem Diamant allein auf seiner Oberfläche stärker verbunden zu sein; und
ein Schritt des Vermischens und des verstärkenden Materials mit einem Matrixmaterial zum Bilden eines Verbundmaterials,
worin die Schicht (3) durch Erwärmen der Oberfläche des Diamanten, welcher als das verstärkende Material dient, zum Umwandeln desselben in Graphit erhalten wird,
**dadurch gekennzeichnet, daß**
der Diamant im wesentlichen aus aufgedampften Diamant besteht, der aus der Gruppe ausgewählt wird, die aus nadelförmigem Diamant, Diamantfasern, Diamantwhisker und porösem Diamant sowie Verbindungen davon besteht, und
die Matrix (1) im wesentlichen aus organischen Polymeren besteht.

12. Verfahren zur Herstellung eines diamantverstärkten Verbundmaterials, welches umfaßt:
einen Schritt des Herstellen eines verstärkenden Materials (2), welches hauptsächlich aus aufgedampften Diamant zusammengesetzt ist, der eine Schicht (3) hat, die es ermöglicht, stärker mit einer Matrix (1) als im Vergleich dazu mit dem Diamant allein auf der Oberfläche verbunden zu sein; und
ein Schritt des Vermischens des verstärkenden Materials mit dem Matrixmaterial zur Bildung eines Verbundmaterials,
**dadurch gekennzeichnet, daß**
die Schicht durch Aufdampfen des dampfenden Diamants erhalten wird, der mit mindestens einem Element dotiert ist, welches aus der Gruppe ausgewählt wird, die aus B, N und Verbindungen davon besteht, und
die Matrix (1) im wesentlichen aus organischen Polymeren besteht.

13. Verfahren zur Herstellung eines diamantverstärktes Verbundmaterials nach Anspruch 12,
worin der Diamant im wesentlichen aus aufgedampften Diamant besteht, der aus der Gruppe ausgewählt wird, die aus nadelförmigen Diamant, Diamantfasern, Diamantwhiskern und porösem Diamant sowie Verbindungen davon besteht.

## Revendications

1. Matériau composite renforcé par du diamant, comprenant :
une matrice (1) ; et
un matériau renforçant (2) dispersé dans ladite matrice (1) et principalement composé de diamant déposé en phase vapeur,
ledit matériau renforçant ayant une couche (3) qui se lie plus fortement à ladite matrice que ne le fait le diamant lui-même, au moins à une partie frontière entre ledit matériau renforçant (2) et ladite matrice (1),
caractérisé en ce que
ladite matrice (1) est essentiellement constituée par des polymères organiques,
ladite couche (3) améliore encore la liaison entre ledit matériau renforçant (2) et ladite matrice (1) par rapport à la liaison en l'absence de ladite couche.

2. Matériau composite renforcé par du diamant selon la revendication 1, dans lequel ledit matériau renforçant est essentiellement constitué par du diamant déposé en phase vapeur choisi dans le groupe constitué par le diamant en forme d'aiguille, la fibre de diamant, la trichite de diamant et le diamant poreux, et les combinaisons de ceux-ci.

3. Matériau composite renforcé par du diamant selon la revendication 1 ou 2, dans lequel ladite couche (3) est essentiellement constituée par du graphite.

4. Matériau composite renforcé par du diamant selon la revendication 2, dans lequel ledit matériau renforçant (2) inclut un diamant dopé avec des atomes dopants d'au moins une matière choisie dans le groupe constitué par B, N et une combinaison de ceux-ci.

5. Matériau composite renforcé par du diamant selon la revendication 4, dans lequel ledit diamant dopé forme ladite couche (3).

6. Matériau composite renforcé par du diamant selon la revendication 4 ou 5, dans lequel la concentration dopante totale desdits atomes dopants est dans la gamme d'environ 50 ppm à environ 20 000 ppm.

7. Matériau composite renforcé par du diamant (2) selon la revendication 4 ou , dans lequel ledit diamant dopé inclut B et N, le rapport de B à N étant d'environ 1:1.

8. Matériau composite renforcé par du diamant (2) selon la revendication 4, dans lequel la quantité d'atomes d'hydrogène présents dans ledit diamant déposé en phase vapeur à la partie d'interface entre ledit diamant et ladite matrice n'est pas supérieure à environ 1 x 10¹⁵/cm² pour améliorer la liaison entre ledit matériau renforçant et ladite matrice.

9. Matériau composite renforcé par du diamant selon la revendication 8, dans lequel ladite quantité d'atomes d'hydrogène est dans la gamme d'environ 1,5 x 10¹³/cm² à environ 1 x 10¹⁵/cm².

10. Matériau composite renforcé par du diamant selon la revendication 8, dans lequel ladite quantité d'atomes d'hydrogène est dans la gamme d'environ 1,5 x 10¹³/cm² à environ 2 x 10¹⁴/cm².

11. Procédé de préparation d'un matériau composite renforcé par du diamant, comprenant :
une étape de préparation d'un matériau renforçant (2) qui est principalement composé de diamant déposé en phase vapeur, ayant une couche (3) capable d'être plus fortement liée à la matrice (1) que ledit diamant, au moins sur sa surface ; et une étape de mélange dudit matériau renforçant avec une matière de matrice pour former un matériau composite,
dans lequel ladite couche (3) est obtenue en chauffant la surface dudit diamant jouant le rôle dudit matériau renforçant pour convertir celui-ci en graphite,
caractérisé en ce que
ledit diamant est essentiellement constitué par du diamant déposé en phase vapeur choisi dans le groupe constitué par le diamant en forme d'aiguille, la fibre de diamant, la trichite de diamant et le diamant poreux, et des combinaisons de ceux-ci,
et ladite matrice (1) est essentiellement constituée par des polymères organiques.

12. Procédé de préparation d'un matériau composite renforcé par du diamant, comprenant :
une étape de préparation d'un matériau renforçant (2) qui est principalement composé de diamant déposé en phase vapeur, ayant une couche (3) capable d'être plus fortement liée à la matrice (1) que ledit diamant, au moins sur sa surface ; et une étape de mélange dudit matériau renforçant avec une matière de matrice pour former un matériau composite,
caractérisé en ce que
ladite couche est obtenue en déposant en phase vapeur du diamant qui est dopé avec au moins un élément choisi dans le groupe constitué par B, N et une combinaison de ceux-ci, et
ladite matrice (1) est essentiellement constituée par des polymères organiques.

13. Procédé de préparation d'un matériau composite renforcé par du diamant selon la revendication 12, dans lequel ledit diamant est essentiellement constitué par du diamant déposé en phase vapeur choisi dans le groupe constitué par le diamant en forme d'aiguille, la fibre de diamant, la trichite de diamant et le diamant poreux, et les combinaisons de ceux-ci.
